# EUROPÄISCHE PATENTSCHRIFT

(11) **EP 2 109 003 B1**
(45) Veröffentlichungstag und Bekanntmachung des Hinweises auf die Patenterteilung: **30.05.2018**
(21) Anmeldenummer: 09157631.4
(22) Anmeldetag: 08.04.2009
(51) Int. Cl.: G03F 7/20, H01L 21/68, H01J 37/317

(54) **Mittels aerostatischer Lagerelemente geführter Tisch für Vakuumanwendung**
Table for vacuum use guided with aerostatic bearing elements
Table guidée à l'aide de palier aérostatiques pour l'utilisation sous vide

(30) Priorität: 11.04.2008 DE 102008019681
(43) Veröffentlichungstag der Anmeldung: 14.10.2009
(73) Patentinhaber: Vistec Electron Beam GmbH, 07745 Jena (DE)
(72) Erfinder: Schubert, Gerhard, 07749 Jena (DE); Jackel, Christian, 06722 Droyßig (DE); Kirschstein, Ulf-Carsten, 07751 Jena (DE); Böhm, Michael, 07749 Jena (DE); Bauer, René, 07745 Jena (DE); Harnisch, Gerd, 07749 Jena (DE); Peschel, Thomas,, 07743 Jena (DE); Risse, Stefan,, 07749 Jena (DE); Schenk, Christoph,, 07747 Jena (DE)
(74) Vertreter: Freitag, Joachim

(56) Entgegenhaltungen:
- EP-A1- 1 211 562
- EP-A1- 1 780 786
- US-A- 4 993 696
- US-A1- 2005 129 339
- US-B1- 6 603 130

## Beschreibung

Die Erfindung betrifft einen mittels Gaslagerelementen präzise geführten Tisch nach dem Oberbegriff des Hauptanspruchs, der für die Vakuumanwendung geeignet ist.

Derartige Tische sind allgemein bekannt, beispielsweise aus der EP 1235115 A2 und der US 6499880 B2.
Derartige vakuumtaugliche gas- oder luftgeführte Tische bestehen üblicherweise aus zwei Achsen, beispielsweise in x- und y-Richtung ausgerichtet, die sich unter Hochvakuumbedingungen bewegen können, wobei für eine nahezu reibungsfreie Bewegung beispielsweise auf einer festen Grundplatte Gas- bzw. Luftlagerelemente verwendet werden. Üblicherweise sind entlang der einen Achse, z.B. der x-Achse, Schlitten auf Führungsschienen, z.B. in Form von Balken, bewegbar, und zwischen diesen Schlitten eine Verbindungsschiene, z.B. in Form eines Querbalkens, in Richtung der anderen Achse, z.B. der y-Achse, angeordnet, an der bzw. dem ein weiterer Schlitten läuft, der beispielsweise eine Tischplattenanordnung trägt.

Zum Betrieb der Gas- bzw. Luftlagerelemente wird unter Druck stehendes Gas benötigt, das den aerostatischen Lagerelementen bzw. Gasführungen zuzuführen ist, wobei für im Vakuum eingesetzte aerostatische Lagerelemente und Führungen es erforderlich ist, das für den Betrieb benötigte und kontinuierlich zugeführte Gas nahezu vollständig wieder abzuführen, bevor es in die Vakuumumgebung gelangen kann. Dazu werden Dichtstrukturen eingesetzt, die aus evakuierbaren Kanälen und Dichtspalten, deren Dichtflächen auch mit den Flächen der Führung zusammenfallen können, aufgebaut sind. Die Kombination aus Absaugkanal und Dichtspalt wird als Absaugstufe bezeichnet. Durch Hintereinanderschaltung mehrerer Absaugstufen kann der Gasstrom in das Vakuum schrittweise reduziert werden.

Die Leitungen zur Zu- und Abführung des Gases dürfen bei einer Relativbewegung zwischen den Komponenten der Gasführung keine Zwangskräfte auf die Führung übertragen, um die Führungseigenschaften nicht zu beeinträchtigen. Im oben erwähnten Stand der Technik werden daher hochflexible Leitungen eingesetzt, oder die Leitungen werden in die Schienen oder Balken zum Bewegen der Schlitten bzw. in die Schlitten selbst integriert. Zur Übergabe des Gases, bei Nutzung integrierter Leitungen, zwischen den relativ zueinander bewegten Komponenten befindet sich in einer Komponente eine Bohrung, die über einem sich in der zweiten Komponente befindenden Kanal läuft. Bei dieser Lösung sind ausgedehnte Dichtspalte erforderlich, die sich auf einer durch den Fahrweg bestimmten Länge der Kanäle erstrecken müssen, wodurch ein großer Bauraum resultiert und Dichtprobleme entstehen können.
Eine weitere Variante, bei einer Relativbewegung des Tisches Zwangskräfte auf die Tischführung infolge von Medienzuführungsleitungen zu vermeiden, ist aus der
EP 1 780 786 A1 bekannt geworden. Hier wird mittels einer zusätzlichen Medienzuführungseinheit, die im Wesentlichen der Tischbewegung folgt, eine Entkopplung von den Trägheitsmomenten durch Leitungen und Schläuche verursachten

Ferner ist in der EP 1 211 562 A1 ein lithographisches Projektionsgerät beschrieben, bei dem im Vakuum Versorgungsleitungen zu einem Objekttisch und/oder zu damit verbundenen Motoren und Sensoren innerhalb einer Schutzhülle geführt werden, die aufgrund von Ausgasungen der Leitungskunststoffe im Vakuum evakuierbar ausgebildet ist. Dabei ist die Tischführung als zweidimensionaler Roboterarm mit drei Drehgelenken ausgebildet, zu der die Versorgungsleitungsschutzhülle im gleichen Muster (drehbar) geführt wird. Nachteilig hieran ist das völlig autarke Vakuumsystem für die Schutzhülle, die nicht zur Gasabführung von einem gasgelagerten Objekttisch genutzt werden kann.

In der zur Erfindung nächstliegenden US 2005/0129339 A1 ist ein statisches Gaslagerungssystem und ein Vakuumtischsystem offenbart, bei dem das Tischsystem ein Gaslager zum Abstützen einer Struktur ohne Kontakt dazu sowie eine Vielzahl voneinander unabhängiger Ableitungskanäle aufweist, die mit einer Vakuumpumpe außerhalb einer Vakuumkammer, in der das Tischsystem aufgenommen ist, in Verbindung stehen, wobei bei Betrachtung der Vakuumkanäle von innen nach außen der äußerste Kanal einen größeren Durchmesser gegenüber dem innersten Kanal aufweist. Dabei sind die Gasabfuhrleitungen als flexible Schläuche oder Faltenbälge ausgebildet, wodurch eine rückwirkungsfreie Beweglichkeit des Tischsystems selbst bei sehr dünnen Leitungen nicht gegeben ist.

Der Erfindung liegt die Aufgabe zugrunde, einen vakuumtauglichen, mittels aerostatischer Lagerelemente präzise geführten Tisch zu schaffen, bei dem bei der Relativbewegung zwischen den Komponenten der Gasführungen keine Zwangskräfte übertragen werden, die die Führungseigenschaften beeinträchtigen könnten, und bei dem eine zufriedenstellende Dichtung zum Vakuum gewährleistet wird.

Dieser Aufgabe wird erfindungsgemäß durch einen mittels Gaslagerelementen bzw. aerostatischen Lagerelementen geführten Tisch mit den kennzeichnenden Merkmalen des Anspruchs 1 in Verbindung mit den Merkmalen des Oberbegriffs gelöst.

Durch die in den Unteransprüchen angegebenen Maßnahmen sind vorteilhafte Weiterbildungen und Verbesserungen möglich.

Dadurch, dass die Absaugleitungen mindestens eine längenveränderliche Leitungsanordnung umfassen, die ein erstes und ein zweites Rohrelement aufweist, die berührungslos ineinander tauchen, wobei zwischen den Rohrelementen mindestens ein Dichtspalt vorgesehen ist, werden die Bewegungen der verfahrbaren Komponente des Tisches nicht negativ beeinflusst, und es werden keine unerwünschten Zwangskräfte auf die aerostatischen Lagerelemente bzw. Gasführungen ausgeübt.

In vorteilhafter Weise sind in die Absaugleitungen sowohl mindestens eine in x-Richtung längenveränderliche Leitungsanordnung als auch mindestens eine in y-Richtung längenveränderliche Leitungsanordnung eingesetzt, wobei jeweils abhängig von der Bewegung in x- oder in y-Richtung sich die Eintauchtiefe zwischen den zwei Rohrelementen verändert.

Besonders vorteilhaft ist, dass so viele längenveränderliche Leitungsanordnungen in x- und y-Richtung vorgesehen sind, wie hintereinander geschaltete Absaugstufen zur schrittweisen Reduzierung des zugeführten Gasstromes in das umgebende Vakuum vorgesehen sind, so dass für die Absaugleitungen jeder Absaugstufe der aerostatischen Lagerelemente eine Leitungsanordnung mit variabler Gesamtlänge zur Verfügung gestellt wird.

Durch die erfindungsgemäße Anordnung der Dichtspalte der längenveränderlichen Leitungsanordnungen parallel zur Verfahrrichtung wird eine vom Bewegungsbereich unabhängige Dichtwirkung erreicht.

In einem bevorzugten Ausführungsbeispiel ist jeweils das erste Rohrelement der in x-Richtung längenveränderlichen Leitungsanordnungen mit der gestellfesten Tragstruktur, die als Grundplatte ausgebildet sein kann, fest verbunden und das jeweilige zweite Rohrelement, das Tauchrohr, an einem ersten Schlitten angeordnet, so dass die Bewegungen des Schlittens entsprechend der x-Achse durch Eintauchen des bzw. der Tauchrohre in das jeweilige feststehende Rohr bzw. das Ausziehen des Tauchrohres nicht beeinträchtigt werden, da auch die Tauchrohre in den feststehenden Rohrelementen berührungslos laufen. Entsprechend sind die Rohrelemente der in y-Richtung längenveränderlichen Leitungsanordnungen einerseits an dem ersten Schlitten oder der Verbindungsschiene und andererseits am zweiten Schlitten angeordnet, so dass auch hier die Bewegung des Schlittens in y-Richtung durch berührungsloses Herausziehen und Eintauchen der Rohrelemente nicht gestört werden.

Der Rohrquerschnitt muss dabei nicht zwingend kreisförmig sein, sondern kann alle zweckmäßigen Formen annehmen, z. B. rechtwinklig gestaltet sein. Vorteilhafterweise sind die durch die x- und y-Richtung vorgegebenen Achsen winkelmäßig zueinander beweglich ausgebildet, wobei die Absaugleitungen zwischen den winkelmäßig veränderbaren Komponenten flexible und/oder elastische Zwischenstücke aufweisen, so dass den Winkelbewegungen gefolgt werden kann.

Eine vorteilhafte Ausführungsform sieht vor, dass zwischen dem ersten und dem zweiten Rohrelement der längenveränderlichen Leitungsanordnungen ein aerostatisches Lagerelement, wie z. B. eine aerostatische Lagerbuchse, zur gleichzeitigen Führung und Dichtung der Rohrelemente angeordnet ist. Besonders vorteilhaft ist bei dieser Anordnung, wenn mehrere nebeneinander liegende längenveränderliche Leitungsanordnungen für die einzelnen Absaugstufen vorgesehen sind und die aerostatischen Lagerelemente der Rohrelemente zu einer Baugruppe zusammengefasst sind. Auf diese Weise kann das aus diesen aerostatischen Lagerelementen in Richtung des Vakuumsystems austretende Gas durch ein- oder mehrstufige Dichtsysteme der aerostatischen Lagerelemente schrittweise reduziert werden, wobei die Absaugkanäle der Dichtstufen mit den entsprechenden längenveränderlichen Leitungsanordnungen verbunden sind.

In einer anderen vorteilhaften Ausführungsform sind mehrere längenveränderliche Leitungsanordnungen der unterschiedlichen Absaugstufen ineinander geschachtelt, wobei zwischen dem ersten und dem zweiten Rohrelement ein Dichtspalt vorgesehen ist und das aus dem Dichtspalt einer Leitungsanordnung austretende Gas jeweils von der Leitungsanordnung mit niedrigerem Druckniveau aufgenommen wird. Auf diese Weise kann das aus der Eintauchstelle der Rohre austretende Gas durch einen einzelnen umlaufenden Dichtspalt reduziert werden, wobei der aus dem Dichtspalt eines ersten Rohrsystems austretende Gasstrom durch ein zweites Rohrsystem aufgenommen wird und nur aus dem Dichtspalt des Rohrsystems mit dem niedrigsten Druck Gas in das Vakuumsystem austritt.

In einer weiteren ebenfalls vorteilhaften Ausführungsform sind mehrere längenveränderliche Leitungsanordnungen unterschiedlicher Absaugstufen nebeneinander liegend angeordnet, und mindestens eine Leitungsanordnung weist ein Dichtsystem zwischen dem ersten und dem zweiten Rohrelement auf, das zwei Dichtspalte und einen dazwischen liegenden Absaugkanal umfasst und mindestens eine Leitungsanordnung, die druckmäßig näher am Vakuum liegt, einen Dichtspalt zwischen dem ersten und dem zweiten Rohrelement aufweist, wobei der Absaugkanal der ersten Leitungsanordnung mit der zweiten, näher am Vakuum liegenden Leitungsanordnung verbunden ist. Auf diese Weise ist wiederum eine Kombination mehrerer Leitungsanordnungen bzw. Rohrsysteme zur Leitung gasförmiger Medien auf verschiedenen Druckniveaus vom Atmosphärendruck bis Hochvakuum möglich, so dass die Absaugkanäle der Dichtsysteme der aerostatischen Lagerelemente mittels Rohrleitungen entsprechender Druckstufen evakuiert werden.

Die Rohrelemente bestehen aus einem Material hoher spezifischer Steifigkeit, geringer Rauheit und geringem Adsorptionsvermögen, beispielsweise aus hochdichter Keramik, so dass aufgrund der geringen Durchbiegung niedrige Dichtspalthöhen stabil eingestellt werden können und somit die austretende Gasmenge reduziert wird und auch bei dem Auseinanderfahren der Rohrelemente nur eine geringe Molekülbelegung auf der Oberfläche des ausfahrenden Rohrelementes stattfindet.

Ausführungsbeispiele der Erfindung sind in der Zeichnung dargestellt und werden in der nachfolgenden Beschreibung näher erläutert. Es zeigen:
- Fig. 1: eine perspektivische Ansicht des erfindungsgemäßen gasgeführten Tisches,
- Fig. 2: eine Aufsicht auf den erfindungsgemäßen Tisch, wobei schematisch die Zuführleitungen zum Zuführen und die Absaugleitungen zum Abführen des Gases zu und von den aerostatischen Lagerelementen dargestellt sind,
- Fig. 3: den schematischen Aufbau eines bei dem erfindungsgemäßen gasgeführten Tisch verwendeten aerostatischen Lagerelements,
- Fig. 4: einen Teilschnitt durch eine erfindungsgemäße längenverstellbare Leitungsanordnung mit Dichtsystem,
- Fig. 5: einen Teilschnitt der erfindungsgemäßen längenveränderlichen Leitungsanordnung nach einem anderen Ausführungsbeispiel mit aerostatischen Lagerelementen zur Führung der Rohrelemente, und
- Fig. 6: einen Teilschnitt durch eine erfindungsgemäße längenveränderliche Leitungsanordnung nach einem anderen Ausführungsbeispiel mit Dichtungssystem.

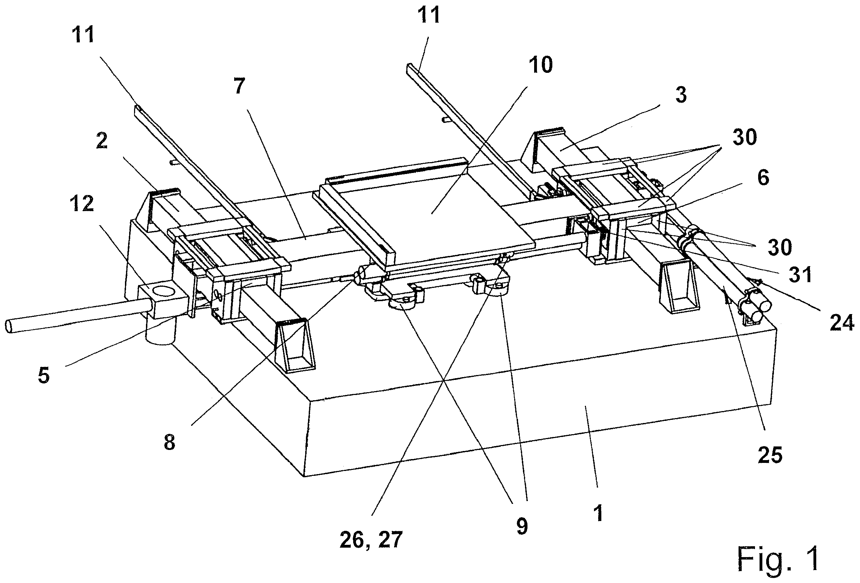

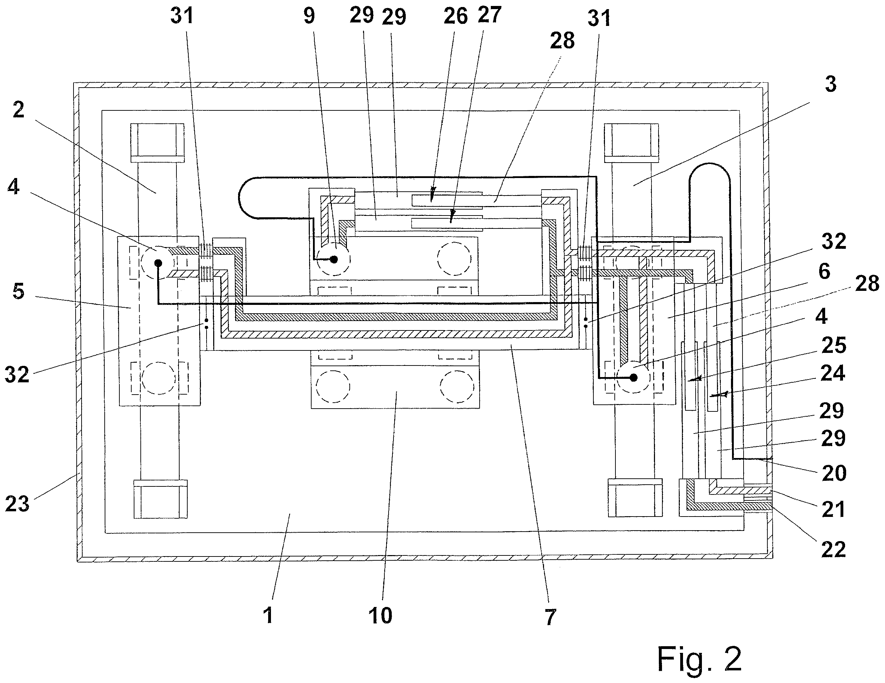

Der in Fig. 1 und Fig. 2 dargestellte präzise mittels aerostatischer Lagerelemente geführte Tisch weist eine gestellfeste Tragstruktur, die als Grundplatte 1 ausgebildet ist, auf, auf der zwei sich entsprechend einer x-Achse bzw. x-Richtung erstreckende Führungsschienen 2, 3, die als Längsbalken ausgebildet sind, befestigt sind. Auf den Führungsschienen 2, 3 laufen über aerostatische Lagerelemente 4 (siehe Fig. 2) bewegliche Schlitten 5, 6 (erste Schlitten). Mit den Schlitten 5, 6 ist eine als Querbalken ausgebildete Verbindungsschiene 7 verbunden, die zusammen mit den Schlitten 5, 6 in x-Richtung verschiebbar ist. An der die y-Achse bildenden Verbindungsschiene 7 läuft ein Schlitten 8, der über aerostatische Lagerelemente 9 auf der Grundplatte 1 geführt ist. Die Lagerelemente 4 und 9 können auch jeweils nur zur Grundplatte oder nur zu den Führungsschienen ausgeführt sein. Der Schlitten 8 trägt eine Tischplatte 10, auf der zu bearbeitende Bauelemente, z. B. Wafer, gelagert werden. Für die beiden Achsen in x- und in y-Richtung sind x-Antriebe 11 und ein y-Antrieb 12 vorgesehen.

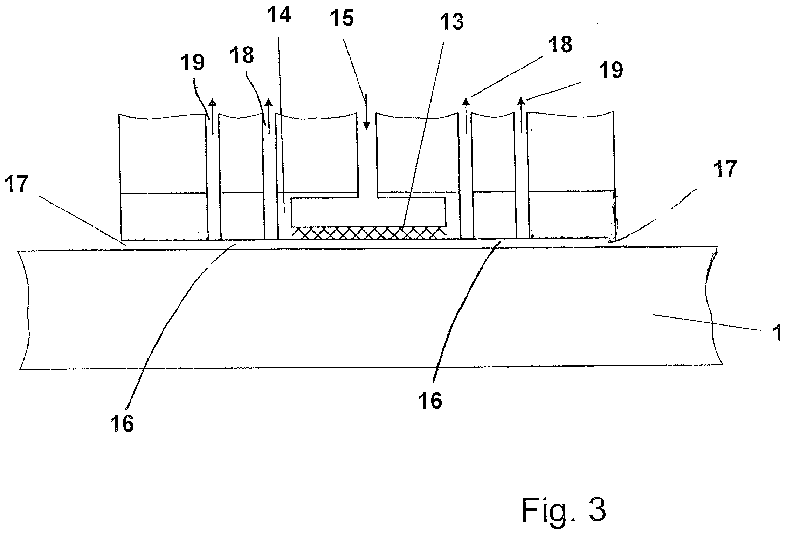

In Fig. 3 ist schematisch ein aerostatisches Lagerelement dargestellt, das beispielsweise den aerostatischen Lagerelementen 9 entspricht. Die Grundplatte ist dabei wieder mit 1 bezeichnet, wobei das Kernstück des Lagerelements die Tragzone 13 ist, in der sich der tragende Luft- oder Gasfilm ausbildet. Die Tragzone 13 ist mit einer Gaszuführung 15 verbunden, wobei über diese Zuführung unter Druck stehendes Gas zugeführt wird, das z.B. über ein poröses Material oder einzelne Düsen gedrosselt in einen Spalt 14 einströmt. Integriert in das aerostatische Lagerelement, die Tragzone umgebend, sind jeweils ein erster Dichtspalt 16 und ein zweiter Dichtspalt 17 vorgesehen, wobei zwischen erstem Dichtspalt 16 und Tragzone 13 ein erster Absaugkanal 18 und zwischen dem ersten und zweiten Dichtspalt 16, 17 ein zweiter Absaugkanal 19 angeordnet ist. Erster Dichtspalt 16 und Absaugkanal 18 bilden eine erste Absaugstufe für ein erstes Vakuum, das im Druckbereich zwischen 10³ Torr und 10⁻²Torr ausgebildet ist, und der zweite Dichtspalt 17 und der zweite Absaugkanal 19 bilden eine zweite Absaugstufe für ein zweites Vakuum in einem Druckbereich von 10⁻¹ Torr bis 10⁻⁶ Torr ausgebildet ist.

Der Gaszuführungskanal 15 ist mit Zufuhrleitungen 20 (siehe Fig. 2) für unter Druck stehendes Gas aus einer nicht dargestellten Gasquelle verbunden, während der Absaugkanal 18 der ersten Absaugstufe mit in Fig. 2 weit schraffiert dargestellten Absaugleitungen 21 und der Absaugkanal 19 der zweiten Absaugstufe mit den eng schraffierten Absaugleitungen 22 verbunden sind. Die Absaugleitungen 21 und 22 sind mit außerhalb der Vakuumkammer 23 angeordneten Vakuumpumpen verbunden.

In Fig. 2 ist nur ein Teil der zu den aerostatischen Lagerelementen 4, 9 geführten Zufuhrleitungen 20 und der von den aerostatischen Lagerelementen 4, 9 wegführenden Absaugleitungen 21, 22 dargestellt; selbstverständlich sind sie auch mit den übrigen Lagerelementen verbunden.

Wie aus Fig. 1 und Fig. 2 zu erkennen ist, sind in die Absaugleitungen 21, 22 längenveränderliche Leitungsanordnungen 24, 25 für die x-Richtung und 26, 27 für die y-Richtung eingesetzt. Für jede Absaugstufe ist eine längenveränderliche Leitungsanordnung in x-Richtung und eine längenveränderliche Leitungsanordnung in y-Richtung vorgesehen. Im vorliegenden Fall sind für die aerostatischen Lagerelemente zwei Absaugstufen vorgesehen; selbstverständlich kann auch nur eine Absaugstufe, aber auch mehr als zwei Absaugstufen vorgesehen werden.

Die längenveränderlichen Leitungsanordnungen 24 - 27 bestehen aus jeweils zwei Rohrelementen 28, 29, die ineinandertauchen, wobei ihre Eintauchtiefe sich entsprechend der Bewegung der Schlitten 6 und 8 in x- und in y-Richtung verändert. Die Rohrelemente 28 der Leitungsanordnung 24, 25, die im vorliegenden Falle Tauchrohre bilden, sind mit dem Schlitten 6 verbunden, während die Rohrelemente 29 feststehend mit der Grundplatte verbunden sind. Die als Tauchrohre dienenden Rohrelemente 28 der Leitungsanordnungen 26 und 27 sind mit der Verbindungsschiene 7 verbunden und die Rohrelemente 29 mit dem Schlitten 8 für die y- Richtung. Die Absaugleitungen 21, 22 weisen Leitungselemente auf, die innerhalb der Schlitten 5, 6, 8 und des Verbindungsbalkens 7 geführt sind, sie können aber auch, wie es die Konstruktion gestattet, teilweise außen an den Schlitten vorgesehen werden. Beispielhaft sind Leitungselemente 30 in Fig. 1 dargestellt.

Im vorliegenden Ausführungsbeispiel sind die Gaszufuhrleitungen 20 als dünne flexible Leitungen ausgebildet, da sie einen wesentlichen geringeren Querschnitt haben dürfen als die Vakuumleitungen zur Absaugung des Gases, und stören daher die Bewegungen der Schlitten nicht. Grundsätzlich können aber auch die Zuführleitungen 20 mit längenveränderlichen Leitungsanordnungen versehen werden.

Falls die y-Achse, hier die Verbindungsschiene 7, beweglich gegenüber der x-Achse angeordnet werden soll, damit eine gewisse Drehung der Tischplatte 10 in der Ebene (x/y) ermöglicht wird, weisen die Absaugleitungen 21, 22 zwischen den Schlitten 5, 6 und den Verbindungselementen zu der Verbindungsschiene 7 flexible, elastische Zwischenstücke 31 auf, so dass Winkelbewegungen der y-Achse mitvollzogen werden können. In diesem Fall sind Gelenkstrukturen 32 vorgesehen.

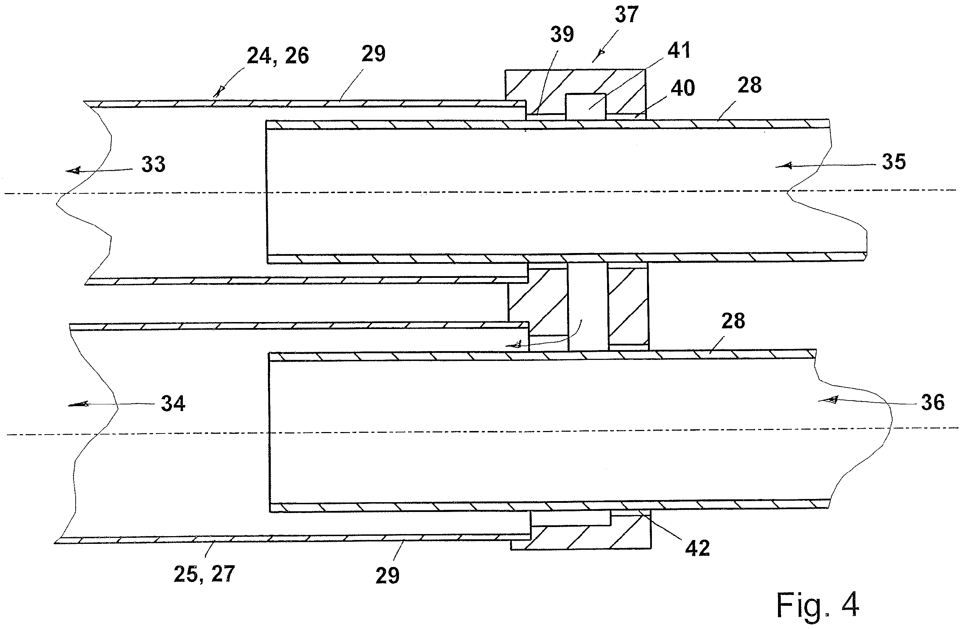

In den Fign. 4, 5 und 6 sind unterschiedliche Ausführungsformen der längenveränderlichen Leitungsanordnungen bzw. ihrer Dichtsysteme an der Eintauchstelle dargestellt. Fig. 4 zeigt zwei längenveränderliche Leitungsanordnungen, eine für die erste Absaugstufe, mit 24, 26 bezeichnet, und eine für die zweite Absaugstufe, mit 25, 27 bezeichnet, wobei gegebenenfalls eine dritte Absaugstufe mit niedrigerem Druck angeordnet werden kann. Der Pfeil 33 gibt die Gasströmungsrichtung zur Vakuumpumpe der Absaugleitungen der ersten Absaugstufe, z. B. einer Vorvakuumpumpe, an, der Pfeil 34 den Gasstrom zur Vakuumpumpe der Absaugleitungen der zweiten Absaugstufe, z.B. einer Hochvakuumpumpe, während die Pfeile 35 und 36 den Gasstrom aus der ersten Absaugstufe der aerostatischen Lagerelemente und den Gasstrom aus der zweiten Absaugstufe der aerostatischen Lagerelemente bezeichnen.

Der Gasstrom kann im übrigen auch in entgegengesetzter Richtung erfolgen.

Die Rohrelemente 28, 29 der Leitungsanordnungen 24 - 27 tauchen berührungsfrei ineinander. Um die eintauchenden Rohre 28 ist ein Dichtsystem 37 vorgesehen, das an den Rohrelementen befestigt ist. Das eintauchende bzw. Tauchrohr 28 der ersten Absaugstufe wird mit zwei Dichtspalten 39, 40 abgedichtet, zwischen denen ein Absaugkanal 41 liegt. Der Dichtspalt 39 stellt die Dichtung zum Absaugkanal 41 dar, während der Spalt 40 diejenige zum Vakuumsystem bildet. Die Dichtspalte weisen eine Höhe im Bereich von 20 bis 60 µm auf. Der Absaugkanal 41 ist direkt mit dem Rohrelement 29 der zweiten Absaugstufe verbunden, wobei das eintauchende Rohr 28 der zweiten Absaugstufe mit einem Dichtspalt 42 in Richtung des Vakuumsystems gedichtet ist. Der aus dem Rohrelement der ersten Absaugstufe austretende Gasstrom ist deutlich größer als der des Rohrelementes der zweiten Absaugstufe.

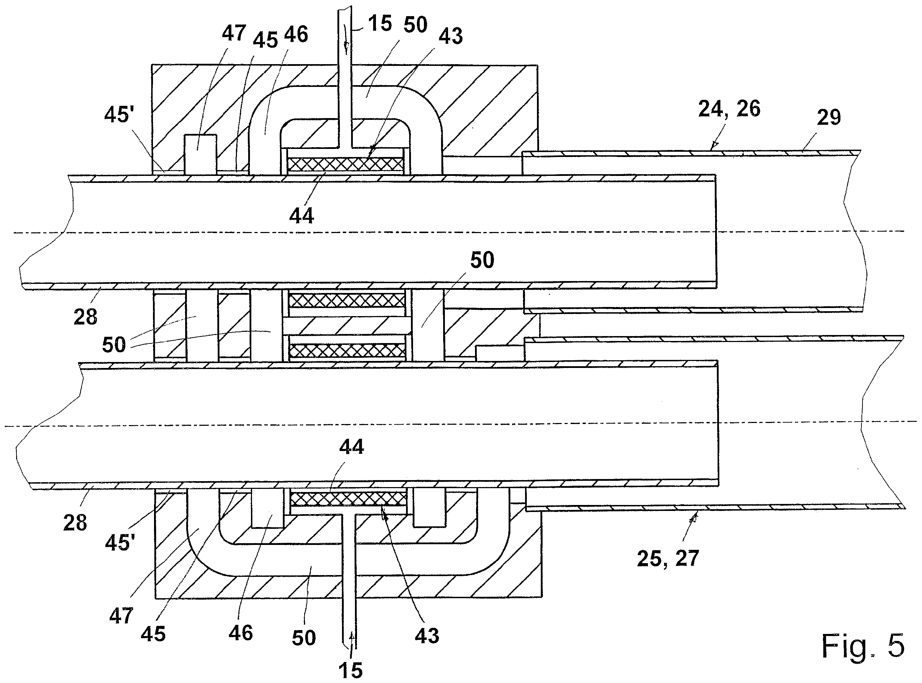

In Fig. 5 wird das eintauchende Rohrelement 28 innerhalb des Rohrelementes 29 mit größerem Durchmesser durch ein aerostatisches Lagerelement 43 in Form einer aerostatischen Lagerbuchse geführt. Die Tragzonen der aerostatischen Lagerelemente 43 sind mit 44 bezeichnet. Die aerostatischen Lagerelemente beinhalten neben einer Gaszuführung 15 auch eine separate Absaugung. Mit dieser Anordnung können sehr geringe Dichtspalthöhen in der Größenordnung von 5 bis 10 µm realisiert werden, die eine sehr gute Dichtwirkung aufweisen. Die Lagerelemente 43 sind als eine Baugruppe für die Rohrelemente beider Absaugstufen zusammengefasst, wodurch die Evakuierung der für die Lagerelemente erforderlichen Dichtstrukturen einfach realisiert werden kann. Innerhalb der aerostatischen Lagerelemente 43 bzw. der Baugruppe ist ein internes Leitungssystem 50 vorgesehen, das die Absaugkanäle mit den entsprechenden längenveränderlichen Leitungselementen verbindet. Die aerostatischen Lagerelemente weisen in Richtung des Vakuumsystems erste Dichtspalte 45 und zweite Dichtspalte 45' auf, wobei zwischen der Tragzone 44 und dem ersten Dichtspalt 45 ein erster Absaugkanal 46 und zwischen dem ersten Dichtspalt 45 und dem zweiten Dichtspalt 45' ein zweiter Absaugkanal 47 vorgesehen ist. In Richtung des Rohrs muss die Tragzone des Rohrelementes der ersten Absaugstufe nicht zusätzlich gedichtet werden. Der in diese Richtung austretende Gasstrom wird direkt durch das Rohrelement abgeführt. Der Gasstrom der Tragzone des Rohrelementes der zweiten Absaugstufe kann nicht unmittelbar in das Rohr eingeleitet werden. Hier ist eine einstufige Absaugung erforderlich. Der in das Vakuumsystem austretende Gasstrom richtet sich nach Durchmesser und Versorgungsparametern der für die längenveränderliche Leitungsanordnung verwendeten aerostatischen Lagerelemente.

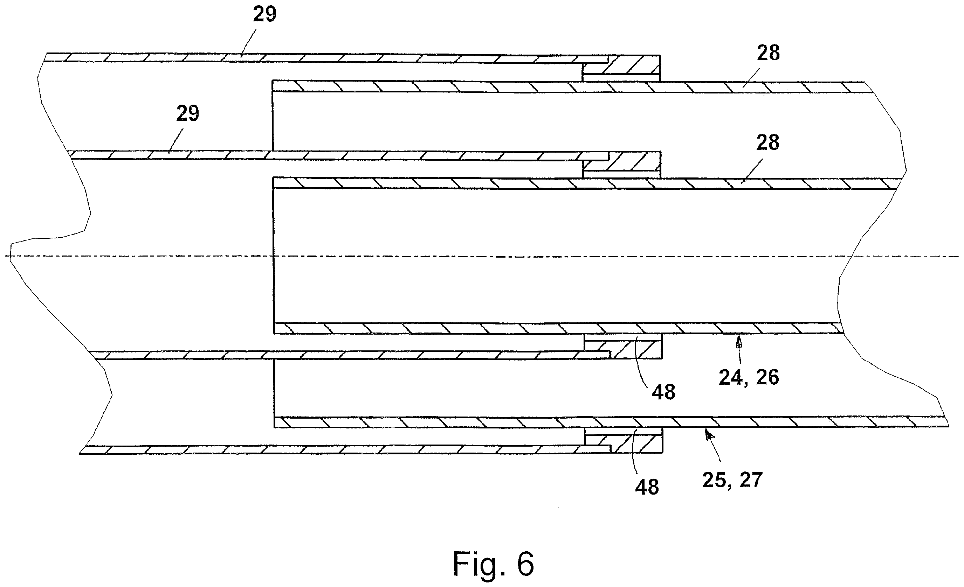

In Fig. 6 sind zwei längenveränderliche Leitungsanordnungen dargestellt, die ineinandergeschachtelt sind, d.h. die Rohrelemente der einzelnen Absaugstufen sind ineinandergeschachtelt. Grundsätzlich tauchen die Rohrelemente der Anordnung wiederum ungeführt ineinander ein, und zwischen den einzelnen Rohrelementen sind Dichtspalte 48 angeordnet. Die Dichtspalthöhe entspricht der der Ausführung nach Fig. 4. Das eintauchende Rohrelement 28 der ersten Absaugstufe ist das innerste Rohrelement. Der aus dem einzigen Dichtspalt 48 des eintauchenden Rohrelementes der ersten Absaugstufe austretende Gasstrom gelangt nicht mehr in das Vakuumsystem, sondern wird direkt von dem eintauchenden Rohr 28 der zweiten Absaugstufe aufgefangen. Das Tauchrohr bzw. das Rohrelement 28 dieser Absaugstufe wird gegenüber dem Vakuumsystem wiederum mit einem einzelnen Spalt 48 gedichtet. Der Gasstrom in das Vakuum beschränkt sich damit auf den Gasstrom, der aus dem Dichtspalt 48 des Tauchrohres bzw. des Rohrelementes 28 der höchsten Absaugstufe des gasgeführten Systems austritt.

## Patentansprüche

1. Mittels aerostatischer Lagerelemente geführter Tisch für Vakuumanwendung mit einer gestellfesten Tragstruktur und einer in x- und y-Richtung über Schlitten bezüglich der gestellfesten Tragstruktur verschiebbaren Tischplatte, wobei die Schlitten mit den aerostatischen Lagerelementen zur Führung versehen sind, die mit Zufuhrleitungen zum Zuführen und Absaugleitungen zum Abführen des zum Betrieb der Gaslager erforderlichen Gases verbunden sind,
**dadurch gekennzeichnet, dass**
jede Absaugleitung (21, 22) mindestens eine längenveränderliche Leitungsanordnung (24, 25, 26, 27) umfasst, die ein erstes und ein zweites Rohrelement (28, 29) aufweist, die berührungslos und mit variabler Länge ineinander eintauchbar sind, um eine Längenveränderung der Leitungsanordnung (24, 25, 26, 27) zu bewirken, wobei zwischen den Rohrelementen (28, 29) mindestens ein Dichtspalt vorgesehen ist.

2. Tisch nach Anspruch 1, **dadurch gekennzeichnet, dass** die Absaugleitungen mindestens eine in x- Richtung längenveränderliche Leitungsanordnung (24, 25) und mindestens eine in y-Richtung längenveränderliche Leitungsanordnung (26, 27) umfassen und die längenveränderlichen Leitungsanordnungen vorzugsweise einer orthogonalen Anordnung der Koordinaten x und y folgen.

3. Tisch nach Anspruch 1 oder Anspruch 2, **dadurch gekennzeichnet, dass** die aerostatischen Lagerelemente (4, 9) mindestens zwei hintereinander geschaltete Absaugstufen zur schrittweisen Reduzierung des in das umgebende Vakuum austretenden Gasstroms aufweisen, wobei die Absaugleitungen (21, 22) der jeweiligen Absaugstufen getrennt voneinander sind und wobei in die Absaugleitungen der jeweiligen Absaugstufen jeweils in x- Richtung und y-Richtung längenveränderliche Leitungsanordnungen (24, 25, 26, 27) geschaltet sind.

4. Tisch nach einem der Ansprüche 1 bis 3, **dadurch gekennzeichnet, dass** sich in x-Richtung mit Abstand zueinander zwei mit der gestellfesten Tragstruktur (1) fest verbundene Führungsschienen (2, 3) erstrecken, auf denen jeweils ein erster Schlitten (5, 6) beweglich angeordnet ist, und dass eine Verbindungsschiene (7) mit den zwei Schlitten (5, 6) verbunden ist, an der ein zweiter Schlitten (8) beweglich angeordnet ist, der die Tischplatte (10) trägt.

5. Tisch nach Anspruch 3, **dadurch gekennzeichnet, dass** das erste Rohrelement (29) der in x- Richtung längenveränderlichen Leitungsanordnung (24, 25) mit der gestellfesten Tragstruktur (1) fest verbunden ist und das zweite Rohrelement (28) an einem ersten Schlitten (6) angeordnet ist und dass das erste Rohrelement (29) der in y-Richtung längenveränderlichen Leitungsanordnung (26, 27) mit der Verbindungsschiene (7) oder dem ersten Schlitten (6) verbunden ist und das zweite Rohrelement (29) am zweiten Schlitten (8) angeordnet ist oder umgekehrt.

6. Tisch nach einem der Ansprüche 1 bis 5, **dadurch gekennzeichnet, dass** die die x- und y-Richtung vorgebenden Achsen winkelmäßig zueinander beweglich ausgebildet sind und dass die Absaugleitungen flexible Zwischenstücke (31) zum Folgen möglicher Winkelbewegungen aufweisen.

7. Tisch nach einem der Ansprüche 1 bis 6, **dadurch gekennzeichnet, dass** zwischen erstem und zweitem Rohrelement aerostatische Lagerelemente, wie eine Gaslagerbuchse (43), zur gleichzeitigen Führung und Dichtung angeordnet sind.

8. Tisch nach Anspruch 7, **dadurch gekennzeichnet, dass** die Gasführungselemente der Rohrelemente (28, 29) mehrerer nebeneinander liegender längenveränderlicher Leitungsanordnungen (24, 25, 26, 27) der einzelnen Absaugstufen in einer Baugruppe zusammengefasst sind.

9. Tisch nach einem der Ansprüche 1 bis 6, **dadurch gekennzeichnet, dass** mehrere längenveränderliche Leitungsanordnungen (24, 25, 26, 27) der unterschiedlichen Absaugstufen ineinander geschachtelt sind, wobei zwischen dem ersten und zweiten Rohrelement (28, 29) ein Dichtspalt (48) vorgesehen ist und das aus dem Dichtspalt (48) einer Leitungsanordnung austretende Gas jeweils von der Leitungsanordnung mit niedrigerem Druckniveau aufgenommen wird.

10. Tisch nach einem der Ansprüche 1 bis 6, **dadurch gekennzeichnet, dass** mehrere längenveränderliche Leitungsanordnungen (24, 25, 26, 27) unterschiedlicher Absaugstufen nebeneinander liegen und mindestens eine Leitungsanordnung (24, 26) ein Dichtsystem zwischen dem ersten und zweiten Rohrelement (28, 29) aufweist, das zwei Dichtspalte (39, 40) und einen dazwischen liegenden Absaugkanal (41) umfasst, und mindestens eine Leitungsanordnung (25, 27), die druckmäßig näher am tischumhüllenden Vakuum liegt, einen Dichtspalt (42) zwischen dem ersten und zweiten Rohrelement aufweist, wobei der Absaugkanal (41) des Dichtsystems der ersten Leitungsanordnungen (24, 26) mit der zweiten Leitungsanordnung (25, 27) verbunden ist.

11. Tisch nach einem der Ansprüche 1 bis 10, **dadurch gekennzeichnet, dass** die Rohrelemente aus einem Material hoher spezifischer Steifigkeit und geringen Absorptionsvermögens, wie hochdichter Keramik, bestehen.

12. Tisch nach einem der Ansprüche 1 bis 11, **dadurch gekennzeichnet, dass** die gestellfeste Tragstruktur als Grundplatte (1) ausgebildet ist.

## Claims

1. Table for vacuum use guided by means of aerostatic bearing elements, having a fixedly mounted supporting structure and a tabletop displaceable by slides in an x-direction and a y-direction with respect to the fixedly mounted supporting structure, wherein the slides are provided with the aerostatic bearing elements for guiding, which aerostatic bearing elements are connected to feed lines for supplying the gas necessary for operation of the gas bearings and suction lines for removing the gas, **characterized in that**
each suction line (21, 22) comprises at least one variable-length line arrangement (24, 25, 26, 27) having a first pipe member (28) and a second pipe member (29) which can penetrate one inside another without contacting one another and with variable length, in order to bring about a variation in length of the line arrangement (24, 25, 26, 27), wherein at least one sealing gap is provided between the first pipe member (28) and the second pipe member (29).

2. Table according to claim 1, **characterized in that** the suction lines comprise at least one line arrangement (24, 25) **characterized by** a length variable in the x-direction and at least one line arrangement (26, 27) **characterized by** a length variable in the y-direction, and the variable-length line arrangements preferably follow an orthogonal arrangement of the coordinates x and y.

3. Table according to claim 1 or claim 2, **characterized in that** the aerostatic bearing elements (4, 9) have at least two suction stages arranged one behind the other for gradually reducing the gas flow exiting into the surrounding vacuum, wherein the suction lines (21, 22) of the respective suction stages are separate from one another, and wherein line arrangements (24, 25, 26, 27) whose length can be varied in x-direction and y-direction, respectively, are arranged in the suction lines of the respective suction stages.

4. Table according to one of claims 1 to 3, **characterized in that** two guide rails (2, 3) which are fixedly connected to the fixedly mounted supporting structure (1) extend in x-direction at a distance from one another, a first slide (5, 6) being movably arranged thereon, respectively, and **in that** a connection rail (7) is connected to the two slides (5, 6), a second slide (8) which supports the tabletop (10) being movably arranged at the connection rail (7).

5. Table according to claim 3, **characterized in that** the first pipe member (29) of the line arrangement (24, 25) whose length can be varied in x-direction is fixedly connected to the fixedly mounted supporting structure (1), and the second pipe member (28) is arranged at a first slide (6), and **in that** the first pipe member (29) of the line arrangement (26, 27) whose length can be varied in y-direction is connected to the connection rail (7) or to the first slide (6), and the second pipe member (29) is arranged at the second slide (8), or vice versa.

6. Table according to one of claims 1 to 5, **characterized in that** the axes defining the x-direction and y-direction are formed so as to be movable at an angle relative to one another, and **in that** the suction lines have flexible intermediate pieces (31) for following possible angular movements.

7. Table according to one of claims 1 to 6, **characterized in that** aerostatic bearing elements such as a gas bearing bushing (43) are arranged between the first pipe member and the second pipe member for simultaneously guiding and sealing.

8. Table according to claim 7, **characterized in that** the gas guide elements of the pipe members (28, 29) of a plurality of adjacently arranged variable-length line arrangements (24, 25, 26, 27) of the individual suction stages are combined to form an assembly.

9. Table according to one of claims 1 to 6, **characterized in that** a plurality of variable-length line arrangements (24, 25, 26, 27) of the various suction stages are nested one inside the other, a sealing gap (48) being provided between the first pipe member (28) and the second pipe member (29), and the gas exiting from the respective sealing gap (48) of a line arrangement being received by the line arrangement with a lower pressure level.

10. Table according to one of claims 1 to 6, **characterized in that** a plurality of variable-length line arrangements (24, 25, 26, 27) of different suction stages are arranged adjacent to one another, and at least one line arrangement (24, 26) has a sealing system between the first pipe member (28) and the second pipe member (29), which sealing system comprises two sealing gaps (39, 40) and a suction channel (41) located therebetween, and at least one line arrangement (25, 27) which is closer with respect to pressure to the vacuum surrounding the table has a sealing gap (42) between the first pipe member and the second pipe member, wherein the suction channel (41) of the sealing system of the first line arrangements (24, 26) is connected to the second line arrangement (25, 27).

11. Table according to one of claims 1 to 10, **characterized in that** the pipe members are made from a material of high specific rigidity and low adsorption capacity such as a high-density ceramic.

12. Table according to one of claims 1 to 11, **characterized in that** the fixedly mounted supporting structure is constructed as a base plate (1).

## Revendications

1. Table pour l'utilisation sous vide guidée au moyen d'éléments de palier aérostatiques, ayant une structure de support montée fixement et un dessus de table déplaçable par des chariots en une direction x et une direction y relative à la structure de support montée fixement, les chariots étant équipés des éléments de palier aérostatiques pour guidage, les éléments de palier aérostatiques étant reliés à des conduites d'alimentation pour alimenter le gaz nécessaire pour l'opération des paliers à gaz et des conduites d'aspiration pour l'extraction du gaz, **caractérisée en ce que**
chaque conduite d'aspiration (21, 22) comprend au moins un agencement de conduites (24, 25, 26, 27) à longueur variable ayant un premier élément tubulaire (28) et un deuxième élément tubulaire (29) qui peuvent pénétrer l'un dans l'autre sans se toucher et avec une longueur variable, pour effectuer une variation de longueur de l'agencement de conduites (24, 25, 26, 27), au moins une fente d'étanchéité étant prévue entre le premier élément tubulaire (28) et le deuxième élément tubulaire (29).

2. Table selon la revendication 1, **caractérisée en ce que** les conduites d'aspiration comprennent au moins un agencement de conduites (24, 25) **caractérisé par** une variation de longueur en direction x et au moins un agencement de conduites (26, 27) **caractérisé par** une variation de longueur en direction y, et les agencements de conduites à longueur variable suivent, de préférence, un agencement orthogonal des coordonnées x et y.

3. Table selon la revendication 1 ou revendication 2, **caractérisée en ce que** les éléments de palier aérostatiques (4, 9) ont au moins deux étapes d'aspiration disposées l'une à la suite de l'autre pour une réduction graduelle du flux de gaz sortant dans le vide environnant, les conduites d'aspiration (21, 22) des étapes d'aspiration respectives étant séparées les unes des autres, et des agencements de conduites (24, 25, 26, 27) dont la longueur peut être variée en direction x et en direction y, respectivement, sont disposés dans les conduites d'aspiration des étapes d'aspiration respectives.

4. Table selon une des revendications 1 à 3, **caractérisée en ce que** deux rails de guidage (2, 3) qui sont reliés à la structure de support montée fixement (1) s'étendent en direction x à distance l'un de l'autre, un premier chariot (5, 6) étant disposé de manière déplaçable la-dessus, respectivement, et **en ce qu'**un rail de liaison (7) est relié aux deux chariots (5, 6), un deuxième chariot (8) qui supporte le dessus de table (10) étant disposé de manière déplaçable au rail de liaison (7).

5. Table selon la revendication 3, **caractérisée en ce que** le premier élément tubulaire (29) de l'agencement de conduites (24, 25) dont la longueur peut être variée en direction x est relié de manière fixe à la structure de support montée fixement (1), et le deuxième élément tubulaire (28) est disposé à un premier chariot (6), et **en ce que** le premier élément tubulaire (29) de l'agencement de conduites (26, 27) dont la longueur peut être variée en direction y est relié au rail de liaison (7) ou au premier chariot (6), et le deuxième élément tubulaire (29) est disposé au deuxième chariot (8), ou inversement.

6. Table selon une des revendications 1 à 5, **caractérisée en ce que** les axes définissant la direction x et la direction y sont construits de manière à être déplaçable à un angle l'un par rapport à l'autre, et **en ce que** les conduites d'aspiration ont des pièces intermédiaires (31) flexibles pour suivre des mouvements angulaires possibles.

7. Table selon une des revendications 1 à 6, **caractérisée en ce que** des éléments de palier aérostatiques, par exemple une douille de palier à gaz (43), sont disposés entre le premier élément tubulaire et le deuxième élément tubulaire pour guider et étancher simultanément.

8. Table selon la revendication 7, **caractérisée en ce que** les éléments de guidage de gaz des éléments tubulaires (28, 29) d'une pluralité d'agencements de conduites (24, 25, 26, 27) à longueur variable disposés de manière adjacente des étapes d'aspiration individuelles sont combinés pour former un assemblage.

9. Table selon une des revendications 1 à 6, **caractérisée en ce qu'**une pluralité d'agencements de conduites (24, 25, 26, 27) à longueur variable des étapes d'aspiration différentes sont emboîtés les uns dans les autres, une fente d'étanchéité (48) étant prévue entre le premier élément tubulaire (28) et le deuxième élément tubulaire (29), et le gaz sortant de la fente d'étanchéité (48) respective d'un agencement de conduites étant reçu par l'agencement de conduites ayant un niveau de pression plus bas.

10. Table selon une des revendications 1 à 6, **caractérisée en ce qu'**une pluralité d'agencements de conduites (24, 25, 26, 27) à longueur variable d'étapes d'aspiration différentes sont disposés de manière adjacente les uns par rapport aux autres, et au moins un agencement de conduites (24, 26) a un système d'étanchéité entre le premier élément tubulaire (28) et le deuxième élément tubulaire (29), le système d'étanchéité comprenant deux fentes d'étanchéité (39, 40) et un canal d'aspiration (41) localisé entre eux, et au moins un agencement de conduites (25, 27) qui est plus proche, à ce qui concerne la pression, au vide entourant la table a une fente d'étanchéité (42) entre le premier élément tubulaire et le deuxième élément tubulaire, le canal d'aspiration (41) du système d'étanchéité des premiers agencements de conduites (24, 26) étant relié au deuxième agencement de conduites (25, 27).

11. Table selon une des revendications 1 à 10, **caractérisée en ce que** les éléments tubulaires sont constitués d'un matériau de haute rigidité spécifique et de basse capacité d'adsorption, par exemple une céramique de haute densité.

12. Table selon une des revendications 1 à 11, **caractérisée en ce que** la structure de support montée fixement est réalisée sous la forme d'une plaque de base (1).
